Europäisches Patentamt

European Patent Office

Office européen des brevets

(11) Veröffentlichungsnummer: **0 341 531**
**A2**

## (12) EUROPÄISCHE PATENTANMELDUNG

(21) Anmeldenummer: 89107859.4

(22) Anmeldetag: 29.04.89

(51) Int. Cl.⁴: **H03G 1/00 , H03D 7/14**

(30) Priorität: 11.05.88 DE 3816075

(43) Veröffentlichungstag der Anmeldung:
**15.11.89 Patentblatt 89/46**

(84) Benannte Vertragsstaaten:
**AT BE CH DE ES FR GB GR IT LI LU NL SE**

(71) Anmelder: **Licentia Patent-Verwaltungs-GmbH**
**Theodor-Stern-Kai 1**
**D-6000 Frankfurt/Main 70(DE)**

(72) Erfinder: **Tränkle, Günther, Dipl.-Phys.**
**Griesmayerstrasse 27**
**D-7910 Neu-Ulm Pfuhl(DE)**
Erfinder: **Deckenbach, Gottfried, Dipl.-Ing.**
**(FH)**
**Reuteweg 17**
**D-7906 Blaustein(DE)**

(74) Vertreter: **Schulze, Harald Rudolf, Dipl.-Ing.**
**Licentia Patent-Verwaltungs-GmbH**
**Theodor-Stern-Kai 1**
**D-6000 Frankfurt/Main 70(DE)**

(54) **Regelbarer Breitbandverstärker.**

(57) Zur Realisierung eines regelbaren Breitbandverstärkers, dessen Stromaufnahme und Ausgangsgleichspannungspegel unabhängig von der Regelspannung ist, wird ein Breitbandverstärker vorgeschlagen, der aus vier Differenzverstärkern besteht, die jeweils zwei Eingänge, zwei Ausgänge, und eine Bezugsspannungselektrode aufweisen. Die beiden Eingänge des ersten Differenzverstärkers sind mit den beiden Eingängen des Breitbandverstärkers, die Bezugsspannungselektrode über eine Konstantstromquelle mit dem einen Pol der Betriebsspannung und der eine Ausgang mit der Bezugsspannungselektrode eines zweiten Differenzverstärkers und der andere Ausgang mit der Bezugsspannungselektrode eines dritten Differenzverstärkers verbunden. Jeweils ein Eingang des zweiten Differenzverstärkers sind miteinander verbunden und jeweils an einen Eingang für die Zuführung der Regelspannung angeschlossen. Ein Ausgang des zweiten Differenzverstärkers ist mit einem Ausgang des dritten Differenzverstärkers verbunden und an die Bezugsspannungselektrode eines vierten Differenzverstärkers angeschlossen. Der jeweils andere Ausgang des

zweiten Differenzverstärkers ist mit jeweils einem Ausgang des vierten Differenzverstärkers und an dem jeweiligen Verbindungspunkt zweier Widerstände angeschlossen, dessen einer Widerstand an den anderen Pol der Betriebsspannung und dessen anderer Widerstand an den beiden miteinander verbundenen Eingängen des vierten Differenzverstärkers angeschlossen ist. Als Ausgang des Breitbandverstärkers können einer oder beide Verbindungspunkte verwendet werden.

FIG. 1

## Regelbarer Breitbandverstärker und einen derartigen Verstärker enthaltende Mischeranordnung

Die Erfindung betrifft einen regelbaren Breitbandverstärker gemäß dem Oberbegriff des Patentanspruchs 1.

Ein derartiger Breitbandverstärker ist z.B. bekannt aus Electronics Letters, Vol. 22, No. 8 (1986) S. 415-516. Bei dem bekannten Breitbandverstärker wird gegenüber zuvor gebräuchlichen Verstärkeranordnungen durch den vierten Differenzverstärker eine Verringerung der bei Regelung der Verstärkung auftretenden Gleichspannungsschwankungen am Verstärkerausgang erzielt. Es verbleibt aber auch nach dieser Stabilisierungsmaßnahme noch eine Gleichspannungsschwankung am Ausgang von rund 12mV über einen Regelbereich von 20dB.

Der vorliegenden Erfindung liegt daher die Aufgabe zugrunde, einen regelbaren Breitbandverstärker der im Oberbegriff des Patentanspruchs 1 genannten Art anzugeben, der über einen großen Regelbereich eine verbesserte Stabilität des Gleichspannungspegels am Verstärkerausgang aufweist.

Die Erfindung ist im Patentanspruch 1 beschrieben. Die Unteransprüche enthalten vorteilhafte Ausführungen und Weiterbildungen der Erfindung. Insbesondere sind Maßnahmen angegeben, mit welchen bei der Stabilisierung auftretende Rauschbeiträge ohne Beeinträchtigung der Grenzfrequenz des Verstärkers weitgehend unterdrückt werden können.

Der erfindungsgemäße Breitbandverstärker ist besonders vorteilhaft einsetzbar als Transadmittanz, d.h. als Spannungs-Stromwandler in einer aus Transadmittanz und Mischstufe kaskadierten Mischeranordnung unter Verwendung von Differenzverstärkern in der Mischstufe, wobei die Ausgangsströme des Breitbandverstärkers die Betriebsströme der Differenzverstärker der Mischstufe bilden. Vorzugsweise ist die Mischstufe als Quadraturmischstufe mit zwei orthogonal angesteuerten Vierquadrantenmultiplizierern ausgeführt. Eine derartige Mischeranordnung zeichnet sich vor allem durch geringe Stromaufnahme, niedriges Rauschen, hohe regelspannungsunabhängige Linearität, großen Regeldynamikbereich und eine gute Rückwärtsisolation aus.

Die Erfindung ist nachfolgend anhand von Ausführungsbeispielen unter Bezugnahme auf die Abbildungen noch eingehend erläutert. Dabei zeigt

FIG. 1 ein Blockschaltbild des Breitbandverstärkers gemäß der Erfindung

FIG. 2 ein ausführliches Schaltbild eines im Breitbandverstärker benützten Differenzverstärkers

FIG. 3 ein Schaltungsdetail zur Signalrauschabstandsverbesserung

FIG. 4 eine Weiterbildung zum regelbaren Vierquadrantenmultiplizierer bzw. zweier regelbarer Vierquadrantenmultiplizierer.

FIG. 5 wie FIG. 4, jedoch Signalaufteilung über Differenzverstärker

FIG. 6 eine Quadraturmischstufe mit Gegentakt-Mischern

FIG. 7 eine schematische Darstellung der einzelnen Stufen einer Mischeranordnung.

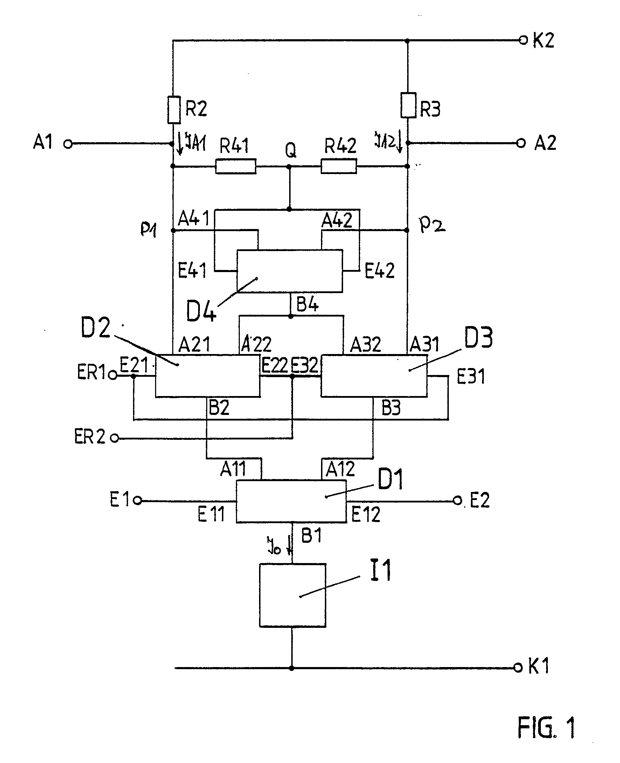

In FIG. 1 ist das Blockschaltbild eines regelbaren Breitbandverstärkers gemäß der Erfindung dargestellt. Er besteht aus vier Differenzverstärkern D1, D2, D3 und D4 mit jeweils zwei Eingängen Eik, zwei Ausgängen Aik und einer Bezugsspannungselektrode Bi, wobei i = 1, 2, 3, 4 den jeweiligen Differenzverstärkern und k = 1, 2 den Ein- und Ausgängen zugeordnet sind. Die beiden Eingänge E11 und E12 des Differenzverstärkers D1 sind mit den beiden Nutzsignaleingängen E1 und E2 verbunden. Die Bezugsspannungselektrode B1 des Differenzverstärkers D1 ist über eine Konstantstromquelle I1 an den einen Pol K1 der Betriebsspannung angeschlossen. Ferner ist der Ausgang A11 mit der Bezugsspannungselektrode B2 des Differenzverstärkers D2 und der andere Ausgang A12 mit der Bezugsspannungselektrode B3 des Differenzverstärkers D3 verbunden.

Die Eingänge der Differenzverstärker D2 und D3 sind parallel geschaltet und jeweils an einem Eingang ER1 bzw. ER2, die für die Zuführung der Regelspannung vorgesehen sind angeschlossen.

Ein Ausgang A22 des Differenzverstärkers D2 ist mit einem Ausgang A32 des Differenzverstärkers D3 verbunden und an die Bezugsspannungselektrode B4 eines Differenzverstärkers D4 angeschlossen. Der jeweils andere Ausgang A21 bzw. A31 der Differenzverstärker D2 und D3 ist mit jeweils einem Ausgang A41 bzw. A42 des Differenzverstärkers und an einem jeweiligen Verbindungspunkt P1 bzw. P2 angeschlossen. Über je einen Widerstand R2 bzw. R3 sind die Verbindungspunkte P1 bzw. P2 an den Pol K2 der Betriebsspannung und an mindestens einem Ausgang A1 bzw. A2 des Breitbandverstärkers angeschlossen. Die Widerstände R2, R3 dienen als Transimpedanz zur Signalauskopplung. Zur Signalauskopplung können in an sich bekannter Weise auch andere Transimpedanzen, eine Kaskodenanordnung, ein Auskoppelstromspiegel oder dergleichen eingesetzt sein.

Gemäß der Erfindung sind zwei in Reihe geschaltete Widerstände R41 und R42 mit gleichem Widerstandswert (gleichwertige Widerstände) vorgesehen, die zwischen die nicht miteinander verbundenen Ausgänge A21, A31 geschaltet sind. Der Verbindungspunkt Q der Widerstände R41 und R42 ist mit den beiden Eingängen E41 und E42 des Differenzverstärkers D3 verbunden.

Die Widerstände R41 und R42 sind hochohmig gegenüber den Widerständen R2 und R3 und haben somit praktisch keinen Einfluß auf die Verstärkung des Breitbandverstärkers.

Die Stromquelle I1, die zwischen der Bezugsspannungselektrode B1 des Differenzverstärkers D1 und dem Pol K1 der Betriebsspannung geschaltet ist, sorgt für eine konstante Stromaufnahme Jo des Breitbandverstärkers. Sie besteht z.B. aus einem mit einem Widerstand in seiner emitterzuleitung gegengekoppelten Transistor in Emitterschaltung. Selbstverständlich kann die Stromquelle auch durch eine an sich bekannte Stromspiegelschaltung realisiert sein, so daß der Spannungsabfall an der Stromquelle sehr gering gehalten werden kann.

Bei einer Aussteuerung des Breitbandverstärkers an seinen Regelspannungseingängen ER1 und ER2 wird beispielsweise der Strom an den Ausgängen A21 und A31 der Differenzverstärker D2 und D3 erhöht und der Strom an den Ausgängen A22 und A32 erniedrigt. Durch die Verbindung der Ausgänge A22 und A32 ist der Summenstrom an der Bezugsspannungselektrode B4 des Differenzverstärkers D4 nur noch von der Regelspannung, nicht aber vom Eingangssignal abhängig. Der Differenzverstärker D4 teilt den Summenstrom in Zwei gleiche Anteile auf und führt diese den beiden Ausgängen A1 und A2 des Breitbandverstärkers zu.

Ein Eingangssignal an den Eingangsklemmen E1, E2 moduliert die Betriebsströme der Differenzverstärker D2 und D3 ge genphasig. Die Ströme an den Ausgängen A21 bzw. A31 sind gegenüber den Betriebsströmen um einen durch Regelspannung eingestellten Faktor geringer. Die über den Differenzverstärker D4 rückgeführten Teilströme sind nicht durch das Eingangssignal moduliert und beeinflussen daher nur den Gleichstromanteil in den Ausgangsströmen JA1, JA2 des Verstärkers bzw. über die Transimpedanzen am Ausgang den Gleichspannungspegel der Ausgangsspannungen an A1, A2. Bei einer Änderung der Regelspannung wird daher nur der Wechselspannungsanteil an den Ausgängen verändert, während der Gleichspannungsanteil konstant bleibt. Es kann ohne weiteres über einen Regeldynamikbereich von 50dB die Schwankung des Gleichspannungspegels am Ausgang geringer als 1mV gehalten werden.

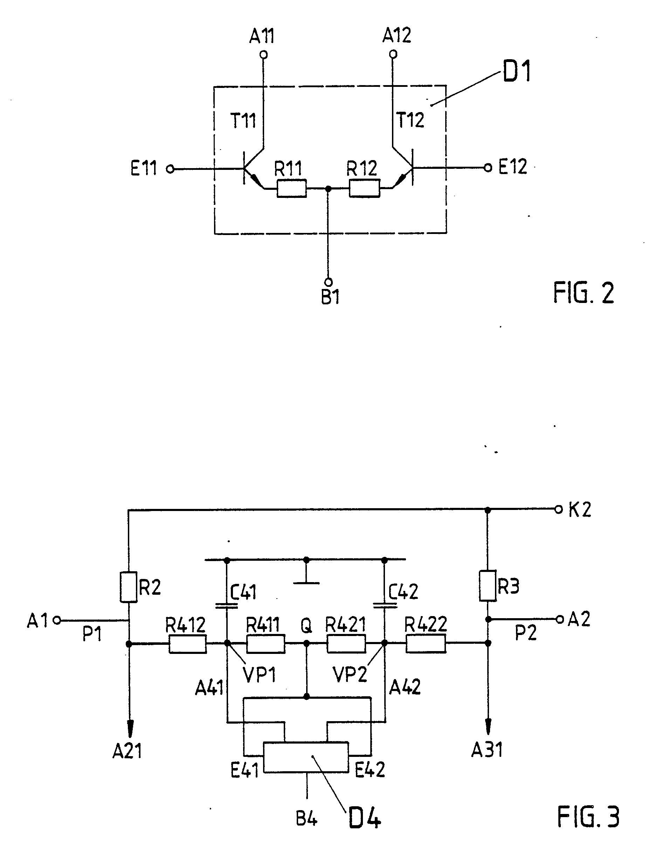

In FIG. 2 ist ein ausführliches Schaltbild des in FIG. 1 als Blockschaltbild dargestellten Differenzverstärkers gezeigt. Die Bezugzeichen beziehen sich auf den Differenzverstärker D1.

Die Differenzverstärker enthalten jeweils zwei Transistoren, z.b. T11 und T12, deren Basisanschlüsse die beiden Eingänge E11 und E12, deren Kollektoranschlüsse die beiden Ausgänge A11 und A12 und deren zusammengeschaltete Emitter die Bezugsspannungselektrode B1 bilden. Die Differenzverstärker D2 bis D4 sind in gleicher Weise aufgebaut und geschaltet.

Die Bezugszeichen und ihre Indizes sind so gewählt, daß die Zuordnung der Anschlüsse zu den Transistorelektroden ohne weiteres erkennbar ist.

Eine vorteilhafte Weiterbildung des regelbaren Breitbandverstärkers sieht vor, jeweils in der Emitterzuleitung der Transistoren T11 und T12 einen Widerstand R11 bzw. R12 zwischenzuschalten. Hierdurch werden in vorteilhafter Weise die Intermodulationsverzerrungen des Verstärkers regelstellungsunabhängig auf zulässigen Werten gehalten. Dadurch verknüpft der hier beschriebene Breitbandverstärker die Eigenschaften Großsignalfestigkeit und gleichstromstabilisierte Ausgänge nahezu regelstellungsunabhängig bei gleichzeitiger hoher Regeldynamik und geringem Rauschbeitrag. Alternativ hierzu können in an sich bekannter Weise auch die Emitter der beiden Transistoren T11, T12 der Eingangsstufe D1 über je eine getrennte Stromquelle mit Bezugspotential und untereinander über einen Gegenkopplungswiderstand verbunden sein. Durch Variation dieses Gegenkopplungswiderstand kann dann die wirksame Gegenkopplung und damit Linearität und Rauschen beeinflußt werden, ohne daß sich die Arbeitspunkte der Transistoren verschieben.

Durch entsprechende Gegenkopplungswiderstände im Differenzverstärker D4 kann und die Gleichheit der Stromaufteilung in D4 besser eingestellt werden.

Der Differenzverstärker D4 teilt den Strom durch B4 symmetrisch auf und liefert daher einen maximalen Rauschbeitrag, der nach FIG. 1 unmittelbar auf die Ausgänge A1, A2 wirkt. Eine vorteilhafte Weiterbildung der Erfindung sieht daher Maßnahmen zur Unterdrückung dieser Rauschanteile vor.

Hierzu sind, wie FIG. 3 zeigt, die Widerstände R41 und R42 in jeweils zwei Widerstände R411 und R412 bzw. R421 und R422 aufgeteilt, der jeweilige Verbindungspunkt VP1 bzw. VP2 durch einen Kondensator C41 bzw. C42 an Massepotential gelegt und die Ausgänge A41 und A42 des Differenzverstärkers D4 mit den jeweiligen Verbindungspunkten verbunden, also Ausgang A41 mit Verbindungspunkt VP1 und Ausgang A42 mit dem Verbindungspunkt VP2. Anstelle der Widerstände R412, R322 können vorteilhafterweise auch Induktivitäten zur Entkopplung der Rauschunterdrückungskondensatoren von den Ausgängen eingesetzt sine, die die Ausgänge für die Nutzsignalfrequenz hochohmig von den Kapazitäten trennen, die für die über D4 fließenden Ruhestromanteile aber keinen Spannungsabfall bewirken. Die Kondensatoren sind vorteilhafterweise in die Schaltungsanordnung integriert und so bemessen, daß die von C41 bzw. C42 und an den Transistoren von D4 wirksamen Ausgangsimpedanzen festgelegte Grenzfrequenz deutlich und der Nutzsignalfrequenz liegt. Bei symmetrischer Signalauskopplung an den Ausgängen A1, A2 können die Kondensatoren C41, C42 ohne Nachteil durch einen Kondensator, zwischen den Punkten VP1 und VP2 geschaltet, ersetzt werden.

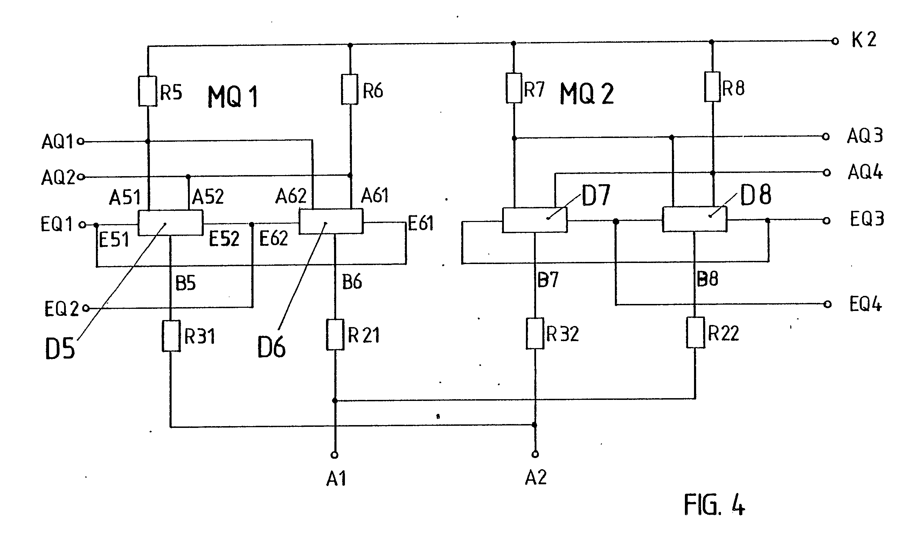

Der erfindungsgemäße regelbare Breitbandverstärker ist besonders vorteilhafte in einer kaskadierten Mischeranordnung als Spannungs-Stromwandler (Transadmittanz) für ein Eingangssignal in der Weise verwendbar, daß die Ausgangsströme des Verstärkers die Betriebsströme einer Mischstufe bilden. Die Kaskadierung einer Transadmittanz mit einer Mischstufe ist an sich bekannt und beispielsweise in IEEE Journal of Solid-State Circuits, Vo. SC-3, No. 4, Dec.1968, S. 365-373 beschrieben. Besonders vorteilhafte Anordnungen weisen mehrere getrennte Mischer in der Mischstufe, beispielsweise für die Quadraturmischung eines Ein gangssignals mit zwei orthogonalen Überlagerungssignalen, auf. FIG. 4 zeigt eine Mischstufe mit zwei Vierquadrantenmultiplizierern als Mischer MQ1, MQ2, die jeweils ein Transistorquartett enthalten. Die Transistorquartette sind jeweils zu zwei eingangsseitig parallel und ausgangsseitig über Kreuz geschalteten Differenzverstärkern zusammengefaßt.

Die parallel geschalteten Eingänge der Differenzverstärker sind mit den Eingängen EQ1 und EQ2 des Multipliziererquartetts verbunden.

Die über Kreuz geschalteten Ausgänge der Differenzverstärker sind an den Ausgängen AQ1 und AQ2 des Multipliziererquartetts angeschlossen und außerdem über je einen Widerstand R5 bzw. R6 an den Pol K2 der Betriebsspannung angeschlossen. Anstelle der Widerstände R5 bzw. R6 kann eine Transimpedanz, ein Auskoppelstromspiegel oder eine resonante Last, vorgesehen sein.

Die Bezugsspannungselektrode B5 wird an den Ausgang A2 des Breitbandverstärkers (FIG. 1) und die Bezugsspannungselektrode B6 an den Ausgang A1 des Breitbandverstärkers angeschlossen. (Die Widerstände R2 und R3 in FIG. 1 entfallen).

Bei Verwendung zweier Multipliziererquartette MQ1 und MQ2 als zweikanaliger Multiplizierer (z.b. Quadraturmischer bei orthogonalem LO-Ansteuersignal), sind Entkopplungswiderstände R21 und R22 bzw. R31 und R32 zur Verbesserung der Stromaufteilung vorteilhaft. Sämtliche Widerstände R21, R22, R31 und R32 haben gleichen Widerstandswert.

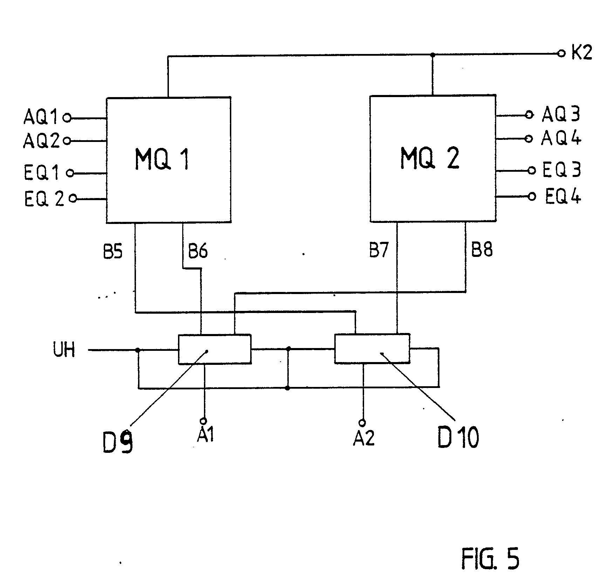

Eine weitere Verbesserung der Gleichheit der Stromaufteilung zwischen gemeinsamer Spannungs-Stromwandlungsstufe einerseits und den beiden Multipliziererquartetten andererseits erlaubt die Aufteilung über Differenzverstärker D9 und D10 (FIG. 5). Die Eingänge der Differenzverstärker D9 und D10 sind an eine, allen Anschlüssen gemeinsame störspannungsfreie Hilfsspannung UH angeschlossen, an die wegen der hochohmigen Einspeisung durch den Breitbandverstärker keine besonderen Anforderungen gestellt zu werden brauchen. Des weiteren sind gleiche Anschlüsse wie in FIG. 4 mit gleichen Bezugszeichen versehen, so daß FIG. 5 keiner weiteren Erläuterungen bedarf.

Die in FIG. 4 und 5 skizzierten Mischer sind auch bekannt als Gilbert-Mischer oder Double-Balanced-Mischer und besitzen den besonderen Vorteil, daß die Oszillatorfrequenz in den Mischerausgangssignalen an AQ1, AQ2 bzw. an AQ3, AQ4 bereits weitgehend unterdrückt ist.

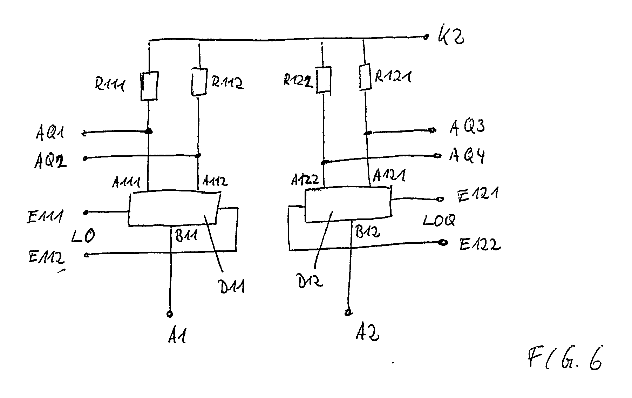

Wenn eine solche Anforderung an die Ausgangssignale nicht besteht, beispielsweise bei einer Anordnung mit Ausfilterung der Nutzsignalanteile im Mischerausgangssignal vor weiteren aktiven Stufen der Signalverarbeitung, können anstelle der Gilbert-Mischer auch einfachere Gegentaktmischer eingesetzt sein wie in FIG. 6 für eine Quadraturmischeranordnung mit zwei Gegentaktmischern (Differenzverstärkern) D11 und D12 skizziert. An den Eingängen E111, E112 des einen Differenzverstärkers D11 liegt ein Oszillatorsignal LO an und die Bezugsspannungselektrode B11 ist mit einem der Ausgänge des Breitbandverstärkers, z.B. A1 verbunden. Die Bezugsspannungselektrode B12 des anderen Differenzverstärkers D12 ist mit dem anderen Ausgang A2 des Breitbandverstärkers verbunden und an den Eingängen E121, E122 liegt ein zu LO orthogonales, d.h. 90° phasenverschobenes Oszillatorsignal LOQ an.

An den Ausgängen A111, A112 bzw. A121, A122 der Differenzverstärker, die über Impdedanzen R111, R112 bzw. R121, R122 an die Klemme K2 der Versorungsspannung angeschlossen sind und bereits die Ausgangsanschlüsse AQ1, AQ2 bzw. AQ3, AQ4 bilden sind dann zwei Ausgangssignale abgreifbar, die neben den Mischfrequenzanteilen auch noch Signalteile der Ansteuersignale enthalten. Aufgrund der symmetrischen Struktur und der Gleichstromstabilisierung der Ausgänge des Breitbandverstärkers fließt durch beide Differenzverstärker D11, D12 der gleiche und regelstellungsunabhängige Ruhestrom.

Für Quadraturmischeranordnungen arbeiten die Differenzverstärker D5 bis D8 bzw. D11, D12 vorzugsweise im Schaltbetrieb, d.h. mit Rechteckansteuersignalen und liefern dann lediglich einen gegenüber den übrigen Komponenten vernachlässigbaren Rauschbeitrag.

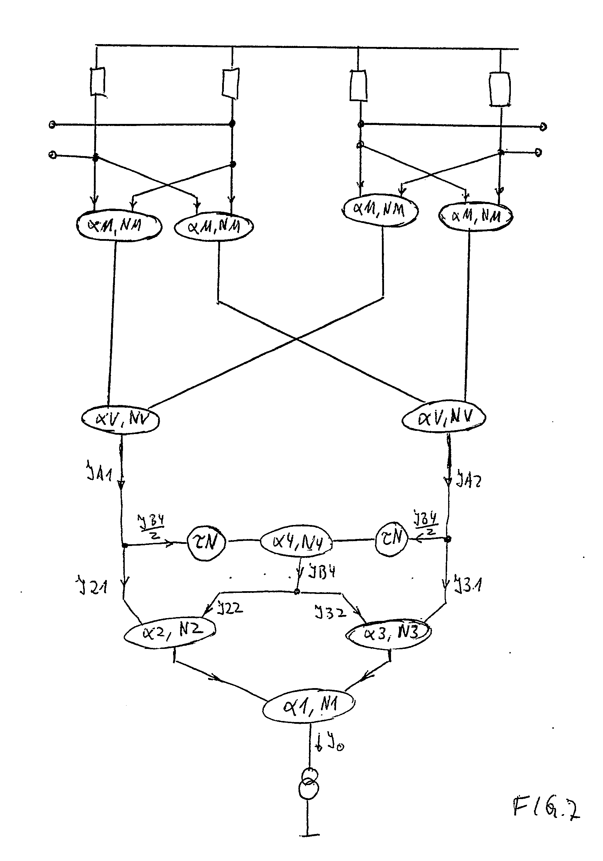

Die gesamte Anordnung von Breitbandverstärkern nach FIG. 1 und Quadraturschaltmischer nach FIG. 4 oder 5 ist in FIG. 7 noch einmal schematisch skizziert mit Unterteilung in aufeinanderfolgende Schaltungsstufen unter Angabe von Stromaufteilungsverhältnissen und Störbeiträgen in den einzelnen Stufen.

Die von dem hochfrequenten Eingangssignal angesteuerte Eingangsstufe D1 teilt den durch die Stromquelle I1 fest gelegten konstanten Betriebsstrom $J_0$ nach Maßgabe des Eingangssignals auf in einem ersten Teilstrom $J11 = \alpha1.J_0$ am Ausgang A11 und einen zweiten Teilstrom $J12 = (1-\alpha1).I_0$ am Ausgang A12. Der Rauschbeitrag N1 der Eingangsstufe stellt den Hauptrauschanteil der gesamten Anordnung dar, so daß der Ausführung der Eingangsstufe maßgebliche Bedeutung zukommt. Dabei führen die Forderungen nach niedrigem Rauschbeitrag, hoher Linearität und geringem Leistungsverbrauch zu teilweise gegenläufigen Tendenzen bei der Festlegung einzelner Parameter. Beispielsweise werden durch hohe Emittergegenkopplungswiderstände die Linearitätseigenschaften verbessert, die Rauscheigenschaften hingegen verschlechtert. Ein hoher Ruhestrom begünstigt ebenfalls die Linearitätseigenschaften, ist aber hinsichtlich des Leistungsverbrauchs nachteilig. Die Dimensionierung im Detail ist daher an den Erfordernissen des Einzelfalls auszurichten. In der die beiden Differenzverstärkerstufen D2 und D3 enthaltenden Regelstufe werden die beiden Teilströme J11, J12 im gleichen, durch die an ER1, ER2 anliegende Regelspannung festgelegten Verhältnis in die Ströme $J21 = \alpha2.J11$, $J22 = (1-\alpha2).J11$, $J31 = \alpha3.J12$ und $J32 = (1-\alpha3)J12$ mit $\alpha2 = \alpha3$ aufgeteilt. Durch Zusammenfassen der Ströme J22 und J32 ergibt sich ein Summenstrom $J2 = J22 + J32 = (1-\alpha2).J_0$, der nur noch vom Aufteilungsverhältnis in der Regelstufe abhängt und keine Nutzsignalanteile mehr enthält. Die Nutzsignalanteile sind nur noch im Gegentakt in den Strömen J21 und J31 mit gegenüber J11, J12 abgeschwächter Amplitude enthalten. Die Rauschbeiträge N2, N3 der Regelstufe sind vom Aufteilungsverhältnis $\alpha2$ abhängig und nehmen für $\alpha2 = 0,5$ ein Maximum an, liegen aber in jedem Falle noch deutlich unter dem Rauschbeitrag N1 der Eingangsstufe.

In der Stabilisierungsstufe mit dem Differenzverstärker D4 wird der Summenstrom $JB4 = J2$ zu gleichen Teilen ($\alpha4 = 0,5$) als Kollektorströme und als Basisströme des Differenzverstärkers D4 den Strömen J21 und J31 zugefügt. Durch die balancierte Ansteuerung der zwei Transistoren des Differenzverstärkers D4 mit gemeinsamem Basispotential und gemeinsamem Emitterpotential wird der Rauschbeitrag dieses Differenzverstärkers maximal. Der Rauschbeitrag des Differenzverstärkers D4 kann verringert werden durch Vergrößern der Transistorflächen und die damit erreichbaren geringeren Bahnwiderstände der Transistoren. Dies

führt aber auch zu höheren Transistorkapazitäten in der Differenzverstärkerstufe D4 und daraus resultiert wiederum eine niedrigere Granzfrequenz der Anordnung. Von besonderem Vorteil ist daher die Einfügung von Rauschsperren $\gamma N$ in die Verbindungen der Differenzverstärkerstufe D4 mit den Ausgängen A1, A2 des Verstärkers wie in FIG. 3 skizziert. Dabei wird das Rauschen der Differenzverstärkerstufe stark unterdrückt und die Widerstände R412, R422 isolieren die Ausgänge A1, A2 von den Kapazitäten der Rauschsperren. Durch die Aufteilung und Rückführung des Stroms JB4 in der Stabilisierungsstufe bleiben die Gleichstromanteile der Gegentakt-Ausgangsströme $JA1 = J21 + JB4/2$ und
$JA2 = J31 + JB4/2$ über einen großen Regelbereich annähernd konstant.

In der Verteilstufe werden die Ausgangsströme JA1 und JA2 jeweils in zwei gleiche Anteile (entsprechend $\alpha V = 0,5$) aufgeteilt und den Bezugsspannungselektroden B5 bis B8 der Mischeranordnung (FIG. 4, 5) zugeführt. Die gleichmäßige Aufteilung kann sowohl über Widerstände wie in FIG. 4 als auch über Differenzverstärker wie in FIG. 5 erfolgen, wobei die Ausführung mit Differenzverstärkern eine bessere Isolation der Mischer, aber auch einen höheren Rauschbeitrag NV aufweist. Wesentlich ist, daß bei der Aufteilung in der Verteilungsstufe das Signal-Ruhestrom-Verhältnis nicht verändert wird, da alle Stromanteile im selben Verhältnis reduziert werden und somit das Signal-RuhestromVerhältnis in den Mischerausgangssignalen bestimmt ist durch die Eingangsstufe und die Regelstufe. Insbesondere steht in der Eingangsstufe die Summe aus den Strömen durch beide Mischerquartette MQ1, MQ2 als Ruhestrom zur Verfügung.

Die Störbeiträge NM der Mischer sind stark von deren Betriebszustand abhängig. Bei Betrieb der Mischer im Schaltmodus mit Ansteuerung der Basisanschlüsse mit Rechtecksignalen sind die im wesentlichen Rauschen und Intermodulationsverzerrungen umfassenden Störanteile durch die Mischer insgesamt gering und von der Flankensteilheit der Rechtecksignale abhängig. Nennenswerte Störbeiträge entstehen in erster Linie zu den Umschaltzeitpunkten. Beim linearen Betrieb der Mischer sind die Störanteile höher und nicht mehr vernachlässigbar.

Das Prinzip der Kaskadierung eines Transadmittanz-Eingangsverstärkers, der eine Eingangsspannung in einen Ausgangsstrom umsetzt, mit mehreren parallel geschalteten Mischern ist auch für Verstärker mit nur einem Stromausgang anwendbar. Der Vorteil, daß Linearität und Rauschverhalten im wesentlichen durch die Eingangsstufe festgelegt und durch die Aufteilung nicht nennenswert beeinträchtigt wer den, gilt auch für diesen Fall und ermöglicht durch das Erfordernis nur einer Eingangsstufe für mehrere Mischstufen insbesondere den Betrieb der Eingangsstufe mit einem relativ höheren Ruhestrom bei insgesamt vertretbarem Leistungsverbrauch der kaskadierten Anordnung. An die Stelle der Mischerquartette MQ1, MQ2 mit Gegentaktansteuerung über A1, A2 treten dann beispielsweise einfache Gegentaktmischerstufen mit nur jeweils einem Differenzverstärker auf.

**Ansprüche**

1. Regelbarer Breitbandverstärker, bestehend aus vier Differenzverstärkern (Di) mit jeweils zwei Eingängen (Eik), zwei Ausgängen (Aik) und einer Bezugsspannungselektrode (Bi), wobei i = 1, 2, 3, 4 den jeweiligen Differenzverstärkern und k = 1, 2 den Ein- und Ausgängen zugeordnet sind),
bei dem die beiden Eingänge (E11, E12) des ersten Differenzverstärkers (D1) mit den beiden Eingängen (E1 und E2) des Breitbandverstärkers, die Bezugsspannungselektrode (B1) über eine Kostantstromquelle (I1) mit dem einen Pol (K1) der Betriebsspannung, der eine Ausgang (A11) mit der Bezugsspannungselektrode (B2) eines zweiten Differenzverstärkers (D2) und der andere Ausgang (A12) mit der Bezugsspannungselektrode (B3) eines dritten Differenzverstärkers (D3) verbunden sind,
bei dem jeweils ein Eingang des zweiten Differenzverstärkers (D2) und ein Eingang des dritten Differenzverstärkers (D3) miteinander (E21 mit E31 und E22 mit E32) verbunden und jeweils an einen Eingang (ER1 bzw. ER2) für die Zuführung der Regelspannung angeschlossen sind,
bei dem ein Ausgang des zweiten Differenzverstärkers (D2) mit einem Ausgang des dritten Differenzverstärkers (D3) verbunden und an die Bezugsspannungselektrode (B4) eines vierten Differenzverstärkers angeschlossen sind (A22 mit A32 an B4),
bei dem der jeweils andere Ausgang (A21 bzw. A31) des zweiten und dritten Differenzverstärkers (D2, D3) über einen Verbindungspunkt (P1 bzw. P2) mit jeweils einem Ausgang (A41, bzw. A42) des vierten Differenzverstärkers (D4), mit einem Ausgang (A1 bzw. A2) des Breitbandverstärkers und über eine Signalauskoppelstufe an den anderen Pol (K2) der Betriebsspannung angeschlossen ist, bei dem die beiden Eingänge (E41 und E42) des vierten Differenzverstärkers (D4) miteinander und mit einer weiteren Spannungsquelle verbunden sind, dadurch gekennzeichnet, daß als weitere Spannungsquelle der Verbindungspunkt (Q) zweier gleichwertiger in Reihe geschalteter Widerstände (R41, R42) vorgesehen ist, wobei die in Reihe geschalteten Widerstände zwischen die nicht miteinander verbundenen Ausgänge (A21 und A31) des zweiten und dritten Differenzverstärkers (D2, D3) geschaltet sind.

2. Verstärker nach Anspruch 1, dadurch gekennzeichnet, daß jeder Differenzverstärker zwei Transistoren enthält, deren Basisanschlüsse die beiden Eingänge, deren Kollektoranschlüsse die beiden Ausgänge und deren zusammengeschaltete Emitter die Bezugsspannungselektrode bilden.

3. Verstärker nach Anspruch 2, dadurch gekennzeichnet, daß beim ersten und/oder vierten Differenzverstärker (D1, D4) in die jeweiligen Emitterzuleitungen der mit der Bezugsspannungselektrode (B1) verbundenen Emitter jeweils ein Widerstand (R11 bzw. R12) geschaltet ist.

4. Verstärker nach einem der vorangegangenen Ansprüche, dadurch gekennzeichnet, daß die zwischen den beiden miteinander verbundenen Eingängen (E41 und E42) des vierten Differenzverstärkers (D4) und jeweils einem Verbindungspunkt (P1 bzw. P2) geschalteten gleichwertigen Widerstände (R41 bzw. R42) in jeweils zwei Teilwiderstände (R411 und R412 bzw. R421 und R422) mit gleichem Teilverhältnis aufgeteilt sind, (R411 = R421 und R412 = R422), daß der jeweilige Verbindungspunkt (VP1, VP2) der beiden Widerstände (R412, R411 bzw. R421, R422) über einen Kondensator (C41, C42) mit Bezugspotential verbunden ist und daß jeweils ein Ausgang (A41 bzw. A42) des vierten Differenzverstärkers (D4) mit dem jeweiligen Verbindungspunkt (VP1, VP2) der beiden Widerstände verbunden ist.

5. Verstärker nach Anspruch 4, dadurch gekennzeichnet, daß die Kondensatoren (C41, C42) zu einem einzigen Kondensator zwischen den Verbindungspunkten (VP1, VP2) zusammengefaßt sind.

6. Mischeranordnung mit einem Verstärker nach einem der vorhergehenden Ansprüche und einer Mischstufe zur Umsetzung eines im Verstärker verstärkten Eingangssignals mit einem oder mehreren überlagerungssignalen, dadurch gekennzeichnet, daß die Ausgänge des Breitbandverstärkers über die Mischstufe am anderen Pol (K2) der Betriebsspannung angeschlossen ist und die Ausgangsströme des Breitbandverstärkers die Betriebsströme der Mischstufe bilden.

7. Mischeranordnung nach Anspruch 6, dadurch gekennzeichnet, daß die Mischstufe einen Mischer in Form eines Vierquadrantenmultiplizierers mit zwei Differenzverstärkern (D5, D6) enthält, daß deren Bezugsspannungselektroden (B5, B6) direkt mit je einem Ausgang (A1, A2) des Breitbandverstärkers verbunden sind, daß die beiden Differenzverstärker eingangsseitig parallel und ausgangsseitig über Kreuz geschaltet sind, daß an die Eingänge (EQ1, EQ2) der Differenzverstärker ein überlagerungssignal angelegt ist und daß die über Kreuz zusammengeschalteten Ausgänge über Signalauskoppelstufen mit dem anderen Pol (K2) der Betriebsspannungsquelle verbunden sind.

8. Mischeranordnung nach Anspruch 7, dadurch gekennzeichnet, daß die Mischstufe zwei oder mehr gleich aufgebaute Mischer in Form von Vierquadrantenmultiplizierern mit jeweils einer ersten und einer zweiten Bezugsspannungselektrode enthält, daß die ersten Bezugsspannungselektroden (B6, B8) mit dem einen Ausgang (A1), die zweiten Bezugsspannungselektroden (B5, B7) mit dem anderen Ausgang (A2) des Breitbandverstärkers parallel und gleichwertig verbunden sind und daß die mehreren Mischer von unterschiedlichen Überlagerungssignalen angesteuert sind.

9. Mischeranordnung nach Anspruch 6, dadurch gekennzeichnet, daß zur parallelen und gleichwertigen Verbindung mehrerer Bezugsspannungselektroden mit einem Ausgang des Breitbandverstärkers mehrere gleichwertige Widerstände (R21, R22 bzw. R31, R32) vorgesehen sind.

10. Mischeranordnung nach Anspruch 8, dadurch gekennzeichnet, daß zur parallelen und gleichwertigen Verbindung zweier Bezugsspannungselektroden mit einem Ausgang (A1, A2) des Breitbandverstärkers ein weiterer Differenzverstärker (D9 bzw. D10) vorgesehen ist.

11. Mischeranordnung nach Anspruch 6, dadurch gekennzeichnet, daß die Mischstufe zwei Gegentaktmischer mit je einem Differenzverstärker (D11, D12) enthält, die über ihre Bezugsspannungselektroden (B11 bzw. B12) mit je einem der beiden Ausgänge (A1, A2) des Breitbandverstärkers verbunden sind.

12. Mischeranordnung nach einem der Ansprüche 8 bis 11, dadurch gekennzeichnet, daß die Meschstufe eine Quadraturmischstufe mit zwei Mischern ist, die von zwei gleichen aber um 90° phasenverschobenen Überlagerungssignalen angesteuert sind.

13. Mischeranordnung nach einem der Ansprüche 6 bis 12, dadurch gekennzeichnet, daß die Mischstufe im Schaltbetrieb arbeitet.

FIG. 1

FIG. 2

FIG. 3

FIG. 4

EP 0 341 531 A2

FIG. 5

FIG. 6

FIG.2